# EUROPÄISCHE PATENTSCHRIFT

(11) **EP 2 845 234 B1**
(45) Veröffentlichungstag und Bekanntmachung des Hinweises auf die Patenterteilung: **11.07.2018**
(21) Anmeldenummer: 13712700.7
(22) Anmeldetag: 07.03.2013
(51) Int. Cl.: H01L 33/60

(54) **VERFAHREN ZUM BESCHICHTEN EINER LEITERPLATTE EINES LED-MODULS**
METHOD OF COATING A CIRCUIT BOARD OF A LED MODULE
PROCÉDÉ DE REVÊTEMENT D'UNE CARTE DE CIRCUIT D'UN MODULE DE DEL

(30) Priorität: 30.04.2012 DE 102012207171; 26.07.2012 DE 102012213178
(43) Veröffentlichungstag der Anmeldung: 11.03.2015
(73) Patentinhaber: Tridonic Jennersdorf GmbH, 8380 Jennersdorf (AT); AT & S Austria Technologie & Systemtechnik Aktiengesellschaft, 8700 Leoben-Hinterberg (AT)
(72) Erfinder: PACHLER, Peter, A-8042 Graz (AT); SZÜCS, Anna, A-8380 Jennersdorf (AT); LANGER, Gregor, A-9061 Wölfnitz (AT); SOMMER, Christian, A-8010 Graz (AT)
(74) Vertreter: Rupp, Christian
(86) Internationale Anmeldenummer: PCT/EP2013/054617
(87) Internationale Veröffentlichungsnummer: WO 2013/164112

(56) Entgegenhaltungen:
- EP-A1- 1 978 566
- WO-A1-2012/002580
- US-A1- 2003 193 055
- US-A1- 2004 066 307
- US-A1- 2004 222 433
- US-A1- 2009 014 732
- US-A1- 2011 198 628
- US-A1- 2013 099 276

## Beschreibung

Die vorliegende Erfindung umfasst ein LED-Modul, das eine beschichtete Leiterplatte aufweist, und die beschichtete Leiterplatte selbst. Die beschichte Leiterplatte dient dazu einen Teil des seitlich von einem LED-Chip des LED-Moduls ausgestrahlten Lichts in Richtung der Normalachse des LED-Moduls zu richten. Insbesondere wird in der folgenden Erfindung ein Verfahren zum Beschichten einer Leiterplatte eines LED-Moduls vorgestellt.

Es ist im Stand der Technik bekannt, eine Leiterplatte mit einer Ausnehmung in einem LED-Modul zu verbauen, um Licht, das von einem LED-Chip des LED-Moduls ausgestrahlt wird, nach außen zu reflektieren und eine Ausstrahlrichtung vorzugeben. Typischerweise ist eine solche Leiterplatte aus einem Kunststoff, dessen Oberfläche mit einer Kupferbahn überzogen ist. Die Kupferbahn ist dazu geeignet Licht zu reflektieren, die Effizienz ist aber gering. Der LED-Chip wird in dem LED-Modul so in der Ausnehmung der Leiterplatte platziert, dass er Licht von hinten durch die Ausnehmung hindurch aus dem LED-Modul heraus strahlt.

Eine solche Kupferbahn auf der Oberfläche eines Kunststoffmaterials weist aber keine zufriedenstellenden Reflexionseigenschaften über den gesamten Spektralbereich des sichtbaren Lichts auf. Insbesondere im Spektralbereich von blauem Licht sind die Reflexionseigenschaften nicht ausreichend.
Beispielsweise bezieht sich die US 2011/0198628 A1 auf eine Multichip-Leuchtdioden (LED) -Packung aufweisend eine gedruckte Leiterplatte (PCB) mit einem sich verjüngenden Durchkontaktierungsloch und einer Schaltungsverbindungsleitung auf einer Oberfläche des PCBs.
Weiterhin bezieht sich die US 2009/0014732 A1 auf eine Chip-Typ Licht emittierende Vorrichtung und ein Verdrahtungssubstrat für die Vorrichtung. Die US 2003/0193055 A1 bezieht sich auf eine Beleuchtungseinrichtung mit einer Leuchtdiode (LED). Die Vorrichtung enthält ein Metallsubstrat mit einer Oberfläche. Eine dielektrische Überzugsschicht ist auf der Oberfläche des Metallsubstrats überlagert. Eine lichtemittierende Diode (LED) ist auf der dielektrischen Überzugsschicht positioniert. Das Metallsubstrat dient als Wärmesenke für die von der LED während des Betriebs abgegebene Wärme.
Die WO 2012/002580 A1 und die US 2013/0099276 A1 beziehen sich auf eine LED-Lichtquellenvorrichtung umfassend: ein Substrat, eine Elektrode, die auf dem Substrat gebildet ist, eine weiße anorganische Resistschicht, die über dem Substrat abgeschieden ist, um eine Oberfläche davon, außer wo die Elektrode gebildet ist, abzudecken, und ein LED-Element, das mit der Elektrode verbunden ist, wobei die weiße anorganische Resistschicht feine weiße anorganische Partikel enthält, die in einem anorganischen Bindemittel dispergiert oder vermischt sind.
Die EP 1 978 566 A1 bezieht sich auf eine Lichtquellenvorrichtung umfassend: ein Substrat, das mindestens ein Paar von Elektroden, mindestens eine lichtemittierende Vorrichtung und ein transparentes Harz zum Abdichten der lichtemittierenden Vorrichtung umfasst, wobei eine weiße Resistschicht auf dem Substrat gebildet ist.

Die US 2004/222433 A1 bezieht sich auf ein LED-Modul mit einem metallischen Träger der mit einer dicken keramischen Schicht überdeckt ist. Auf der Oberfläche dieser keramischen Schicht, in deren Ausnehmung eine Leuchtdiode angeordnet ist, kann eine reflektierende Schicht aufgesprüht werden.

Die vorliegende Erfindung schlägt deshalb als Grundidee vor, eine Oberfläche einer Leiterplatte mit einer hochreflektiven Schicht zu versehen. Allerdings sind herkömmliche Beschichtungsprozesse, wie beispielweise Siebdruck oder Curtain-Coating, dafür nicht gut geeignet, da sie keine zufriedenstellende gleichmäßige Beschichtung insbesondere der Begrenzungswände einer Ausnehmungen der Leiterplatte erzielen. Außerdem besteht die Gefahr, dass während solcher Prozesse die Rückseite der Leiterplatte mit dem aufzubringenden Material undefiniert kontaminiert wird. Siebdrucke können zwar zunächst für gröbere Strukturen verwendet werden, sind aber für feinere Strukturen ungeeignet.

Die vorliegende Erfindung stellt sich zur Aufgabe alle genannten Nachteile des Stands der Technik zu verbessern. Insbesondere ist es eine Aufgabe der vorliegenden Erfindung, die Lichtausbeute eines LED-Moduls zu erhöhen und ein verbessertes Verfahren für das Beschichten einer Leiterplatte bereitzustellen. Dazu soll speziell eine Leiterplatte mit verbesserten Reflexionseigenschaften für ein LED-Modul hergestellt werden. Außerdem strebt die Erfindung an, die Nachteile gängiger Prozesse und Verfahren zu vermeiden. Insbesondere sollen die Begrenzungswände von Ausnehmungen in einer Leiterplatte mit guten Reflexionseigenschaften versehen werden.

Die vorliegende Erfindung löst die oben genannten Aufgaben gemäß dem Gegenstand des unabhängigen Anspruchs 1. Die abhängigen Ansprüche entwickeln den Kerngedanken der Erfindung auf vorteilhafte Weise weiter.

Die vorliegende Erfindung wird im Folgenden anhand der beigefügten Figuren im Detail beschrieben.
Fig. 1 zeigt ein LED-Modul gemäß einem Beispiel, das nicht Teil der Erfindung ist, mit einer beschichteten Leiterplatte.
Fig. 2 zeigt wie eine Leiterplatte mit einem Verfahren gemäß einem Beispiel, das nicht Teil der Erfindung ist, beschichtet wird.
Fig. 3 zeigt wie eine Leiterplatte mit einem Verfahren gemäß der vorliegenden Erfindung beschichtet wird.
Fig. 4 zeigt ein LED-Modul gemäß einem Beispiel, das nicht Teil der Erfindung ist, mit einem Farbkonversionselement.
Fig. 5 zeigt ein LED-Modul gemäß einem Beispiel, das nicht Teil der Erfindung ist, mit einem Farbkonversionselement.
Fig. 6 zeigt ein LED-Modul gemäß einem Beispiel, das nicht Teil der Erfindung ist, mit Farbkonversionselement.
Fig. 7 zeigt ein LED-Modul gemäß einem Beispiel, das nicht Teil der Erfindung ist, mit Farbkonversionselementen.
Fig. 8 zeigt ein LED-Modul gemäß einem Beispiel, das nicht Teil der Erfindung ist, mit Positionierungselementen.
Fig. 9 zeigt ein LED-Modul gemäß einem Beispiel, das nicht Teil der Erfindung ist, mit Positionierungselementen.
Fig. 10 zeigt ein LED-Modul gemäß einem Beispiel, das nicht Teil der Erfindung ist, mit Positionierungselementen.

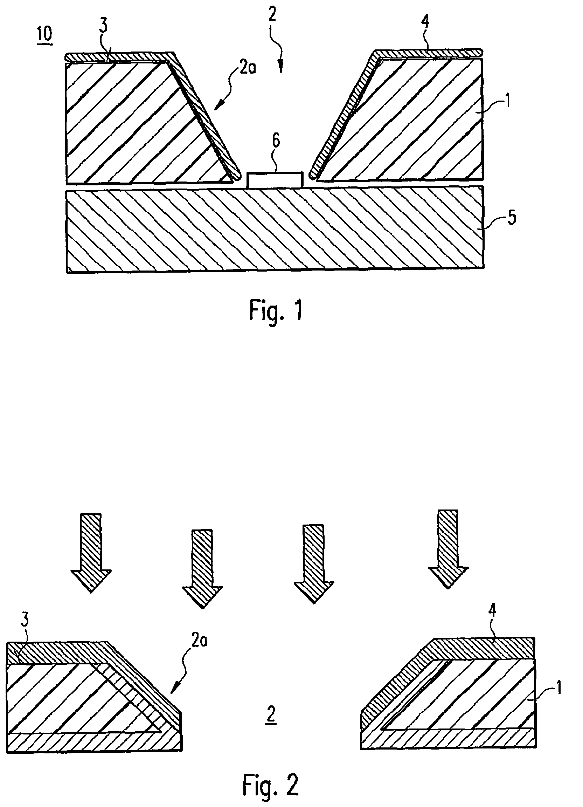

Fig. 1 zeigt ein LED-Modul 10 gemäß einem Beispiel, das nicht Teil der Erfindung ist, sowie eine Leiterplatte 1. Die Leiterplatte 1 ist Teil des LED-Moduls 10, aber auch einzeln von dem Beispiel umfasst. Das LED-Modul 10 besteht aus wenigstens einem LED-Chip 6, der auf einer Trägerplatte 5 aufgebracht ist. Der wenigstens eine LED-Chip 6 kann zum Beispiel eine herkömmliche LED, eine OLED, eine Anordnung von mehreren LEDs oder eine LED-Strecke sein. Mehrere LEDs können entweder gleichfarbiges oder verschiedenfarbiges Licht aussenden. Zur Aufbringung des wenigstens einen LED-Chips 6 auf der Trägerplatte 5 kann dieser angelötet, angeklebt, aufgesteckt oder eingeklemmt werden. Dazu kann die Trägerplatte 5 gegebenenfalls geeignete Aufnahmemittel für den wenigstens einen LED-Chip 6 aufweisen.

Die Trägerplatte kann mehrschichtig aufgebaut sein. Die Trägerplatte 5 kann Materialien enthalten, die beispielweise Aluminium, Gold, Paladium, Nickel und/oder ein Dielektrikum enthalten. Der wenigstens eine LED-Chip 6 ist auf einer Oberfläche auf der Vorderseite der Trägerplatte 5, d. h. einer Oberfläche in Richtung der Ausstrahlseite des LED-Moduls 10, angebracht. Die Trägerplatte 5 ist wiederum an die Rückseite (in Lichtausstrahlrichtung gesehen) einer Leiterplatte 1 angebracht. Dazu kann die Trägerplatte 5 mit der Leiterplatte 1 verklebt, verlötet oder angesteckt werden. Ein leitfähiges Material der Trägerplatte 5, beispielweise eine Kupferschicht, kann dabei elektrisch mit der Leiterplatte 1 verbunden sein. An die Trägerplatte 5 kann rückseitig ferner eine Wärmesenke 16 angebracht sein, um Wärme von dem wenigstens einen LED-Chip 6 abzuführen. Die Wärmesenke kann beispielweise mit Kühllamellen ausgestattet sein.

Der wenigstens eine LED-Chip 6 wird in wenigstens einer Ausnehmung 2 der Leiterplatte 1 platziert. Die Ausnehmung 2 kann eine Bohrung sein, oder kann eine Aussparung sein, die bereits während der Herstellung der Leiterplatte 1 gefertigt wird. Der wenigstens eine LED-Chip 6 wird so hinter oder in der Ausnehmung 2 positioniert, dass das von ihm ausgestrahlte Licht von hinten durch die Ausnehmung 2 der Leiterplatte 1 hindurch aus der Vorderseite des LED-Moduls 10 ausgestrahlt wird. Die Ausnehmung 2 in der Leiterplatte 1 dient als ein Mittel zum Reflektieren und zum Leiten des ausgestrahlten Lichts. Dadurch tritt das Licht gerichtet aus dem LED-Modul 10 aus. Die elektronische Ansteuerung des wenigstens einen LED-Chips 6 wird auf oder in der Trägerplatte 5 geführt.

Die Leiterplatte 1 besteht vorzugsweise aus einem Kunststoffmaterial, beispielsweise aus einem FR4 glasfaserverstärkten Epoxid. Die Wärmeleitfähigkeit der Leiterplatte liegt vorzugsweise in einem Bereich von 0.1 bis 1 W/mK, mehr bevorzugt 0.2 bis 0.4 W/mK. Die Dicke der Leiterplatte kann zwischen 0.1 und 2 mm liegen. Die Leiterplatte 1 ist in der Regel auf einer ihrer Oberflächen (d. h. auf ihrer Vorderseite oder Rückseite) mit einer metallischen Bahn, beispielsweise einer Kupferbahn, überzogen. Es können aber auch andere geeignete Materialien wie Aluminium verwendet werden. Die metallische Bahn weist vorzugsweise eine Wärmeleitfähigkeit in einem Bereich von etwa 140 bis 500 W/mK auf, mehr bevorzugt etwa 300 bis 500 W/mK, noch mehr bevorzugt etwa 380 W/mK-420 W/mK. Zur Aufbringung der metallischen Bahn können herkömmliche Beschichtungsverfahren verwendet werden. Die metallische Bahn könnte auch zusätzlich zur Übermittlung von Strom oder Spannungssignalen an den wenigstens einen LED-Chip 6 verwendet werden.

Die Begrenzungswände 2a in der wenigstens einen Ausnehmung 2 der Leiterplatte 1 nehmen einen Winkel mit der leitfähigen Oberfläche 3 der Leiterplatte 1 auf der Vorderseite des LED-Moduls 10 ein, der in einem Bereich von etwa 10° bis 90°, vorzugsweise in einem Bereich von 30° bis 60°, noch weiter bevorzugt 40° bis 50° liegt, oder am meisten bevorzugt 45° ist. Dadurch kann das von dem wenigstens einem LED-Chip 6 ausgesandte Licht ideal nach außen aus dem LED-Modul 10 reflektiert und geleitet werden.

Um die Reflektivität der Leiterplatte 1 weiter zu erhöhen, insbesondere um die Reflexionseigenschaften über den gesamten Spektralbereich auszudehnen, wird die Oberfläche der Leiterplatte mit einer hochreflektiven Schicht 4 versehen. Die beschichtete Oberfläche kann die leitfähigen Kupferbahnen aufweisen. Die leitfähigen Kupferbahnen können aber auch auf einer anderen Oberfläche der Leiterplatte 1 als der beschichteten Oberfläche vorgesehen sein. Die hochreflektive Schicht 4 wird dabei sowohl auf die (optional leitfähige) Oberfläche 3 auf der Vorderseite des LED-Moduls 10 als auch auf der (optional leitfähigen) Oberfläche 3 auf den Begrenzungswänden 2a der Ausnehmung 2 aufgebracht. Die Schicht kann beispielsweise eine Schicht sein, die UV-Licht widersteht und Temperaturen bis zu mehreren 100° aushält, ohne ihre Reflexionseigenschaften zu verlieren. Dadurch wird die Zuverlässigkeit des LED-Moduls 10 erhöht und die Lebensdauer verlängert.

Eine Möglichkeit eine solche hochreflektive Schicht 4 auszubilden ist dafür eine Tinte zu verwenden, die mit hochreflektiven Partikeln wie Keramikpartikeln versetzt ist. Diese Partikel sind vorzugsweise im Mikrometer- oder Nanometermaßstab, beispielweise 0.15 bis 0.45 µm. Die Schicht ist vorzugsweise 5 bis 50 µm dick, mehr bevorzugt 20 bis 30 µm. Die Schicht erhöht die Reflexionseigenschaften im gesamten sichtbaren Bereich insbesondere auch im blauen Spektralbereich. Dies ist vorteilhaft bei der Erzeugung von weißem Licht. Die oben genannte Tintenschicht kann beispielsweise mittels eines Tintenstrahldruckverfahrens auf die Leiterplatte 1 aufgebracht werden. Die Größe der Partikel in der Tinte ist so gewählt, dass die Viskosität der Tinte problemlos mit einem Tintenstrahldruckverfahren auf die Oberfläche 3 der Leiterplatte 1 gesprüht werden kann. Trotzdem ist die Menge an Partikeln in der Tinte auch so gewählt, dass sehr gute Reflexionseigenschaften über den gesamten gewünschten Spektralbereich erzielt werden. Die hochreflektive Schicht 4 wird gleichmäßig auch auf den schrägen Begrenzungswänden 2a aufgebracht. Auch wenn die Begrenzungswände sehr steil, d. h. annähernd 90° sind, kann mittels des Verfahrens der vorliegenden Erfindung eine gleichmäßige Beschichtung mit der hochreflektiven Schicht 4 erzielt werden.

Fig. 2 veranschaulicht wie das Beschichtungsverfahren der Leiterplatte 1 des LED-Moduls 10 ausgeführt wird. Die Grundidee des Verfahrens ist das einseitige Aufbringen, vorzugsweise Aufsprühen hochreflektiver Materialien auf eine Leiterplatte 1 mit wenigstens einer Ausnehmung 2. Wie oben beschrieben kann das Verfahren ein Tintenstrahldruckverfahren sein. Als hochreflektive Schicht 4 wird dann vorzugsweise wie oben beschrieben eine Tinte basierend auf hochreflektiven Partikeln beispielweise aus Keramik aufgebracht.

In Fig. 2 ist zu sehen, wie durch einen gerichteten Aufsprühstrahl (dargestellt durch die Pfeile) eine hochreflektive Schicht 4 sowohl auf der Oberfläche 3 auf der Vorderseite des LED-Moduls bzw. der Leiterplatte 1 entsteht, als auch auf den vorzugsweise schräg stehenden Begrenzungswänden 2a der Ausnehmung 2. Allerdings kann durch den Winkel eine unterschiedliche Schichtdicke entstehen. Typische Unebenheiten in Ausnehmung 2, die typischerweise durch Bohrungen oder andere Verfahren (z. B. Fräsen, Laserschneiden, Stanzen o. ä.) hergestellt werden, sind im Bereich von 1 bis 50 µm, vorzugsweise 10 bis 50 µm. Vorzugsweise wird die hochreflektive Schicht 4 deshalb mit einer Dicke zwischen 5 und 50 µm aufgetragen. Die hochreflektive Schicht 4 ist vorzugsweise über die gesamte Oberfläche 3 der Leiterplatte 1, d. h. auch an den Begrenzungswänden 2a der Ausnehmung 2 gleich dick.

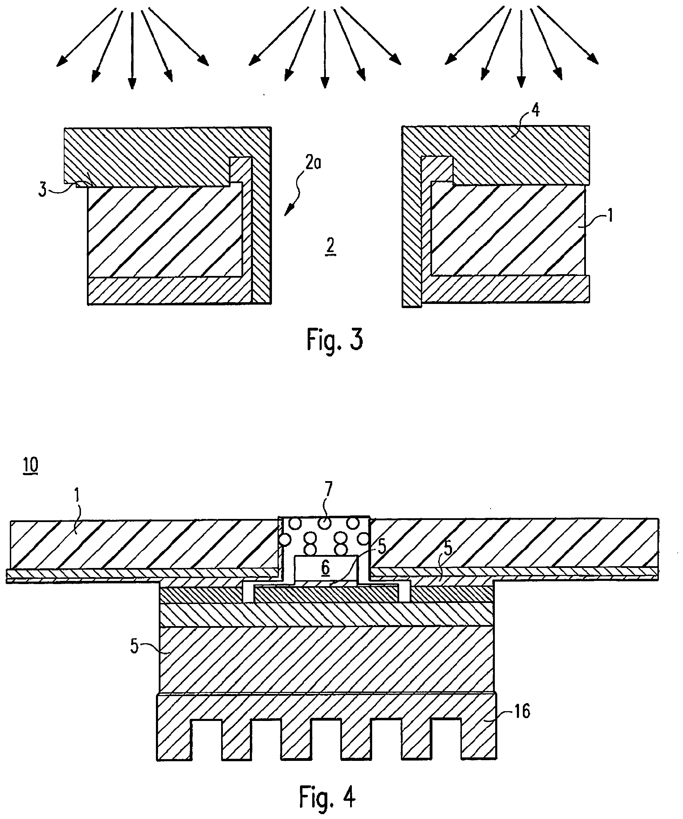

Dazu kann, wie in Fig. 3 gezeigt, der Sprühstrahl (wiederum dargestellt durch die Pfeile) ausgerichtet, d. h. auch in seiner Richtung verändert werden. Somit wird es möglich z. B. auch sehr steil stehende Begrenzungswände 2a (beispielweise in einem Winkel von etwa 90°) mit einer hochreflektiven Schicht 4 zu versehen. Gleichzeitig ist es möglich, die Schicht über die komplette Oberfläche 3 der Leiterplatte 1 gleichmäßig dick aufzusprühen.

Der Sprühstrahl kann entweder gezielt oder zufällig in seiner Richtung und/oder Stärke (d. h. Sprührate des Materials) variiert werden. Der Sprühstrahl kann auch eine kontinuierliche Änderung seiner Richtung vollziehen, so dass wenigstens über einen vorgegebenen Sprühbereich in alle Richtungen gleich viel Material versprüht wird. Alternativ kann allerdings auch eine Schichtdickenmessung während des Aufsprühens durchgeführt werden. Dabei sind gängige Verfahren denkbar, z. B. ein Verfahren, das die derzeitige Rate des versprühten Materials misst, oder ein Verfahren, das die Schichtdicke mittels eines Lasers misst. Das Ergebnis einer solchen Dickenmessung kann der Vorrichtung, die das erfindungsgemäße Verfahren durchführt, zurückgeführt werden. Basierend auf der gemessenen Dicke der hochreflektiven Schicht 4 kann dann die Ausrichtung des Sprühstrahls und/oder dessen Stärke verändert werden, um eine gleichmäßige Schicht über die gesamte Oberfläche 3 zu erzielen.

Wie in Fig. 3 angedeutet, kann auch mehr als ein Sprühstrahl zum Aufsprühen der hochreflektiven Schicht 4 auf die Leiterplatte 1 verwendet werden. Die Ausrichtungen und/oder Stärken der mehreren Sprühstrahle können entweder gemeinsam oder individuell verändert werden. Es kann auch beispielsweise in jedem Sprühbereich der mehreren Sprühstrahle eine gesonderte Schichtdickenmessung durchgeführt werden. Somit könnte durch eine Mehrfachmessung der Schichtdicke und eine gesonderte Ansteuerung der einzelnen Sprühstrahle eine äußerst gleichmäßige hochreflektive Schicht 4 gebildet werden.

Insbesondere kann auch sichergestellt werden, dass die hochreflektive Schicht zuverlässig die gewünschte Schichtdicke, bevorzugt zwischen 5 und 50 µm, erhält.

Durch das einseitig gerichtete Aufsprühverfahren der hochreflektiven Schicht 4 auf die Leiterplatte 1 wird auch verhindert, dass die Rückseite 1 der Leiterplatte mit dem hochreflektiven Material undefiniert kontaminiert wird. Dies könnte nämlich zur Folge haben, dass die Anbringung der Trägerplatte 5 an die Rückseite der Leiterplatte 1 nicht optimal funktioniert, dass die Festigkeit der Verbindung ungenügend ist oder dass die Rückseite der Leiterplatte 1 Unebenheiten aufweist, welche die Richtung der Lichtausstrahlung verändern und somit einen negativen Einfluss der Lichtausbeute des LED-Moduls 10 haben. Das Verfahren ist ferner flexibel einsetzbar, so dass Leiterplatten 1 mit verschiedenen Ausnehmungen 2 beschichtet werden können. Insbesondere Leiterplatten 1 mit Ausnehmungen 2 mit verschieden geformten Begrenzungswänden 2a, d. h. beispielsweise Begrenzungswänden die in verschiedenen Winkeln zur Hauptebene der Leiterplatte 1 stehen, können mit einer gleichmäßigen Schicht 4 versehen werden. Das Verfahren ist schnell und kostengünstig und erzielt eine hohe Ausbeute.

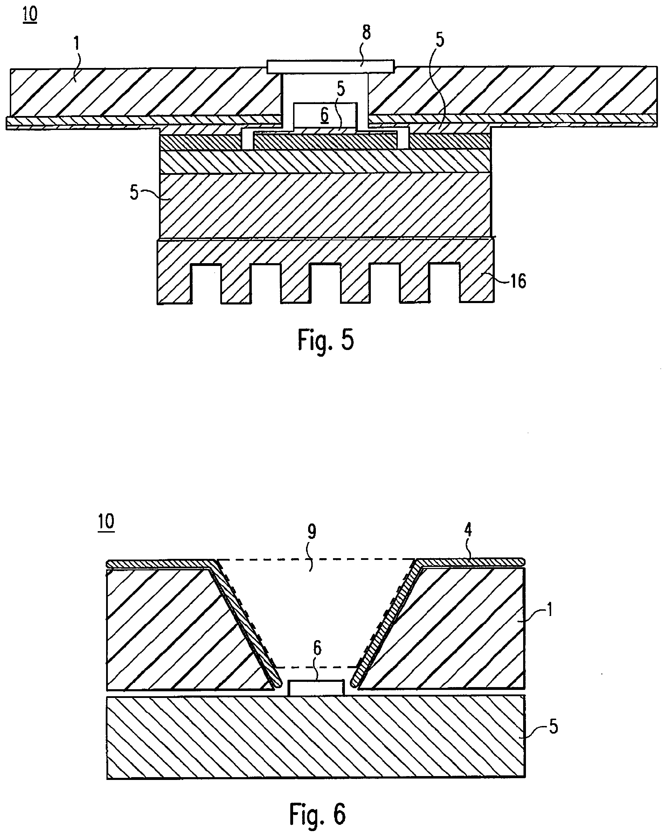

Die Leiterplatte 1, welche wie beschrieben bevorzugt aus FR4 besteht, bildet einen sogenannten Board-in-Board Aufbau mit der Trägerplatte 5, die den wenigstens einen LED-Chip 6 trägt. Die Trägerplatte 5 besteht aus einem Material, welches vom Leiterplattenmaterial 1 verschieden ist und bevorzugt aus IMS (Insulated Metal Substrate) besteht. Über dem wenigstens einen LED-Chip 6 kann ein Farbkonversionsmaterial 7 angeordnet werden. Dazu kann in einer Ausführungsform die gesamte Ausnehmung 2 mit einem Farbkonversionsmaterial 7 ausgefüllt werden, wie in Fig. 4 gezeigt. Alternativ oder zusätzlich kann wie in Fig. 5 gezeigt auch ein vorgefertigtes Plättchen 8 in Form eines keramischen Farbkonversionsplättchens oder ein mit Phosphor versehenes Glas über die Öffnung der Ausnehmung 2 aufgesetzt werden. Ein solches Farbkonversionsplättchen 8 (beispielweise aus Keramik, Phosphor in Glas, Phosphor in Silikon) kann extern vorgefertigt werden.

Es kann auch wie in Fig. 6 gezeigt ein Farbkonversionseinsatz 9 bereitgestellt werden, der vorteilhafterweise Seitenwände aufweist, die den Begrenzungswänden 2a der Ausnehmung 2 angepasst sind. Das heißt, die Seitenwände des Einsatzes 9 sollten denselben Winkel wie die Begrenzungswände 2a der Ausnehmung 2 aufweisen, in die der Farbkonversionseinsatz 9 eingesetzt wird. In einer bevorzugten Ausführung beträgt der Winkel der Seitenwände des Farbkonversionseinsatzes 45°. Farbkonversionsplättchen 8 oder Farbkonversionseinsätze 9 können durch ein entsprechendes Ausschneiden aus einer Farbkonversionsschicht gefertigt werden, wobei in einer bevorzugten Ausführung jeweils der Schnittwinkel 45° beträgt.

Der Farbkonversionseinsatz 9 wird in die Ausnehmung 2 der Leiterplatte 1 eingesetzt. Da in einem bevorzugten Ausführungsbeispiel sowohl der Farbkonversionseinsatz 9 als auch die Begrenzungswände 2a der Leiterplatte 1 einen Winkel von 45° besitzen, kann der Farbkonversionseinsatz direkt in die Leiterplatte 1 eingesetzt werden. Bei anderen Winkeln zwischen 10° und 90° weisen vorteilhafterweise die Seitenwände des Farbkonversionseinsatzes 9 eben diesen Winkel von 10° bis 90° auf. Durch die Fixierung des Farbkonversionseinsatzes in der Ausnehmung 2 der Leiterplatte 1 ist insbesondere auch eine genaue Ausrichtung des Farbkonversionseinsatzes 9 gegenüber dem wenigstens einen LED-Chip 6 möglich.

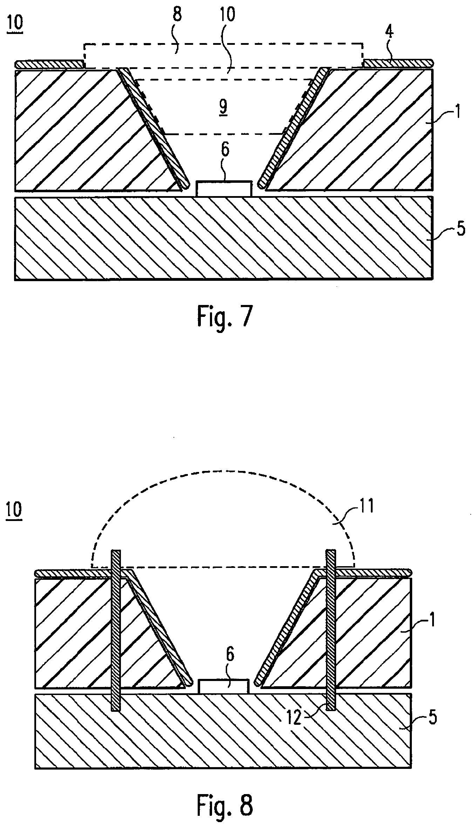

In einer weiteren Ausführung sind auf der Leiterplatte 1 mindestens zwei Farbkonversionselemente untergebracht wie etwa in Fig. 7 gezeigt ein Farbkonversionsplättchen 8 und ein Farbkonversionseinsatz 9. Es ist allerdings auch ein Farbkonversionsplättchen 8 und eine Füllung der Ausnehmung 2 mit Farbstoffmaterial als Kombination von Farbkonversionselementen denkbar. Die beiden Farbkonversionselemente können aus dem gleichen Phosphormaterial bestehen. Die Konzentration des Phosphormaterials in den beiden Elementen kann gleich oder unterschiedlich sein. Das Phosphormaterial des Plättchens 8 kann auch verschieden vom Phosphormaterial des Einsatzes 9. sein. Jedes der beiden Farbkonversionselemente kann dabei auch gleichzeitig mehr als nur eine Sorte Phosphormaterial enthalten. Die beiden Farbkonversionselemente können direkt übereinander angebracht sein oder durch einen Spalt 16 voneinander getrennt sein. Der Spalt 16 kann mit Silikon oder einem anderen zumindest teilweise transparenten Material gefüllt sein. Der Spalt 16 kann auch Luft enthalten.

In einer weiteren Ausführung kann der Aufbau des LED-Moduls 10 auch zur Einstellung einer gewünschten Farbtemperatur verwendet werden. Dazu wird zunächst ein Farbkonversionsplättchen 8 und/oder Farbkonversionseinsatz 9 angebracht und der Farbort in einem CIE-Diagramm gemessen. Aus einer Anzahl weiterer Farbkonversionsplättchen 8 und/oder Farbkonversionseinsätze 9 unterschiedlicher Dicke, Phosphorkonzentration und/oder Phosphorzusammensetzung wird jenes Farbkonversionselement ausgewählt, mit welchem die gewünschte Farbtemperatur, d. h. der gewünschte Farbort im CIE-Diagramm, am besten angenähert werden kann.

Auf der Leiterplatte 1 kann über der Ausnehmung 2 wie in Fig. 8 gezeigt auch eine weitere Sekundäroptik 11 (diffraktiv oder refraktiv) oder ein sekundäroptisches Element angebracht. Dies kann zum Beispiel eine Linse oder ein Globe-Top mit wenigstens einem Farbkonversionsmaterial und/oder Streupartikeln sein.

Für den Board-in-Board Aufbau muss sowohl die Trägerplatte 5 mit den LED-Chips 6 gegenüber der Leiterplatte 1 ausgerichtet werden, als auch die optionale Sekundäroptik 11 gegenüber der Leiterplatte 1 ausgerichtet werden. Dies kann dazu führen, dass es zu Ungenauigkeiten in der Ausrichtung der Sekundäroptik 11 gegenüber dem wenigstens einen LED-Chip 6 kommt. Ziel ist es aber, sowohl die Trägerplatte 5 als auch die optionale Sekundäroptik 11 gegenüber der Leiterplatte 1 so auszurichten, dass es zu möglichst geringen Abweichungen in der Ausrichtung der LED-Chips 6 gegenüber der Sekundäroptik 11 kommt. Dies kann im Allgemeinen dadurch erreicht werden, dass in der Leiterplatte 1 ein oder mehrere Marker integriert werden und sowohl die Trägerplatte 5 als auch die Sekundäroptik 11 während eines Zusammenbaus des Board-in-Board Aufbaus gegen diese Marker ausgerichtet werden.

Insbesondere kann beispielweise wie in Fig. 8 gezeigt eine geeignete Positionierungseinheit 12 (beispielweise ein Markerstift) verwendet werden, um die beiden Platten 1 und 5 gegeneinander auszurichten. Diese Positionierungseinheit 12 kann auch dazu dienen, die Sekundäroptik 11 gegenüber der Leiterplatte 1 auszurichten. In einer bevorzugten Ausführung ist die Positionierungseinheit 12 derartig gestaltet, dass sowohl die Leiterplatte 1 als auch die Sekundäroptik 11 auf diese Positionierungseinheit 12 aufgesetzt werden. Ein Beispiel wäre wenigstens ein Positionierungsstift 12, welcher sowohl an der Oberseite als auch auf der Unterseite aus der Leiterplatte 1 herausragt, wie es in Fig. 8 dargestellt ist. Sowohl die Trägerplatte 5 als auch die Leiterplatte 1 werden entsprechend diesem wenigstens einen Positionierungsstift 12 eingesetzt.

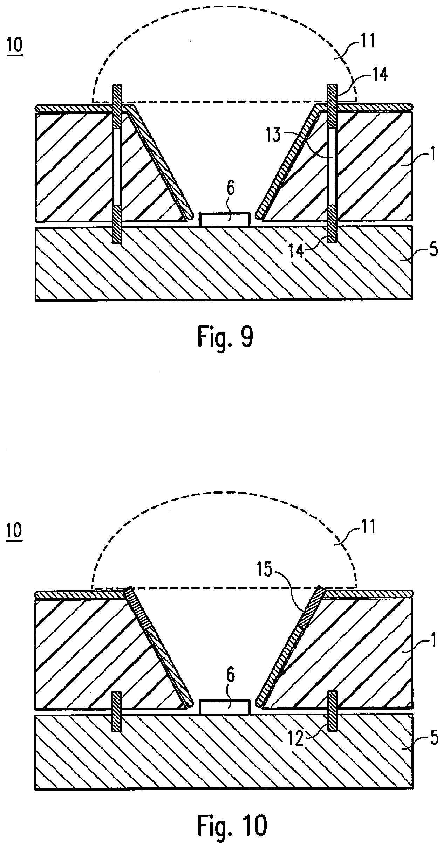

In einer weiteren Ausführung ist wie in Fig. 9 gezeigt eine Positionierungseinheit 13 als Hohlraum in der Leiterplatte 1 ausgeführt. Dieser Hohlraum 13 kann durchgehend sein oder teilweise mit dem Leiterplattenmaterial aufgefüllt sein. Die Trägerplatte 5 und die Sekundäroptik 11 weisen dann beispielweise an ihrer Unterseite einen stiftförmigen Fortsatz 14 auf, dessen Durchmesser kleiner oder gleich dem Durchmesser des Hohlraums 13 in der Leiterplatte 1 ist. Sowohl die Trägerplatte 5 als auch die Sekundäroptik 11 können mit diesem stiftförmigen Fortsatz 14 in den Hohlraum 13 eingesetzt werden.

In einer weiteren Ausführungsform wird wie in Fig. 10 gezeigt die Leiterplatte 1 gegenüber der Trägerplatte 5 nach einem der oben angeführten Beispiele durch eine Positionierungseinheit 12, 13 (zum Beispiel ein Marker, ein Markierungsstift oder ein Hohlraum) ausgerichtet. Die Ausrichtung der Sekundäroptik 11 gegenüber der Leiterplatte 1 erfolgt hingegen dadurch, dass die Sekundäroptik 11 an ihrer Unterseite eine Fortsetzung 15 hat, deren Durchmesser kleiner oder gleich dem Durchmesser der Ausnehmung 2 in der Leiterplatte 1 ist. In einer bevorzugten Ausführung ist der Durchmesser der Fortsetzung 15 an der Unterseite der Sekundäroptik 11 nur unwesentlich kleiner als der Durchmesser der Ausnehmung 2 in der Leiterplatte 1, so dass die Sekundäroptik 11 durch Einsetzen in die Ausnehmung 2 der Leiterplatte 1 ausgerichtet werden kann.

Zusammenfassend stellt die vorliegende Erfindung ein Verfahren zur Beschichtung einer Leiterplatte 1 des LED-Moduls 10 vor, mit dem die Lichtausbeute eines LED-Moduls 10 deutlich erhöht werden kann. Dies wird dadurch erreicht, dass die Leiterplatte 1 zum besseren Reflektieren des von wenigstens einem LED-Chip 6 ausgestrahlten Lichts zusätzlich mit einer hochreflektiven Schicht 4 beschichtet wird. Das Beschichten wird dabei als Aufsprühvorgang durchgeführt, mit welchem die Schicht 4 gleichmäßig aufgetragen werden kann und eine Kontamination von anderen Flächen der Leiterplatte 1 oder der Trägerplatte 5, auf der der wenigstens eine LED-Chip 6 angebracht ist, verhindert werden kann. Das LED-Modul 10 kann ferner wenigstens ein Farbkonversionselement 7, 8, 9 aufweisen, das bevorzugt in oder über der wenigstens einen Ausnehmung 2 der Leiterplatte 1 angebracht wird. Schließlich können Positionierungselemente 12, 13 beim Zusammenbau des LED-Moduls 10 insbesondere bei der Ausrichtung der Leiterplatte 1 und der Trägerplatte 5 zueinander helfen.

## Patentansprüche

1. Verfahren zum Beschichten einer Leiterplatte (1) eines LED-Moduls (10), wobei die Leiterplatte (1) wenigstens eine Ausnehmung (2) und eine Oberfläche (3) aufweist und auf die Oberfläche (3) eine hochreflektive Schicht (4) aufgesprüht wird, wobei die hochreflektive Schicht (4) mittels eines Sprühstrahls auf die Oberfläche (3) aufgesprüht wird,
**dadurch gekennzeichnet, dass**
der Sprühstrahl ausgerichtet werden kann, wobei die Ausrichtung des Sprühstrahls so gewählt und/oder variiert wird, dass die hochreflektive Schicht (4) auch gleichmäßig auf die seitlichen Begrenzungswände (2a) der wenigstens einen Ausnehmung (2) aufgesprüht wird.

2. Verfahren gemäß Anspruch 1, wobei die hochreflektive Schicht (4) durch ein Tintenstrahldruckverfahren aufgesprüht wird.

3. Verfahren gemäß einem der Ansprüche 1 oder 2, wobei die hochreflektive Schicht (4) wenigstens aus einem UV-stabilen und/oder temperaturstabilen Material gebildet wird.

4. Verfahren gemäß einem der Ansprüche 1 bis 3, wobei die hochreflektive Schicht (4) wenigstens aus einer Tinte gebildet wird, die auf hochreflektiven Partikeln basiert.

5. Verfahren gemäß Anspruch 4, wobei die hochreflektiven Partikel einen Durchmesser aufweisen, der in einem Bereich von etwa 1 nm bis 2 µm liegt.

6. Verfahren gemäß einem der Ansprüche 1 bis 5, wobei die hochreflektive Schicht (4) etwa 5 bis 50 µm dick aufgesprüht wird.

## Claims

1. A method for coating a circuit board (1) of an LED module (10), wherein the circuit board (1) has at least one recess (2) and a surface (3) and a highly reflective layer (4) is sprayed onto the surface (3), wherein the highly reflective layer (4) is sprayed onto the surface (3) by means of a spray jet,
**characterized in that**
the spray jet can be aligned, wherein the alignment of the spray jet is selected and/or varied such that the highly reflective layer (4) is also sprayed uniformly onto the lateral boundary walls (2a) of the at least one recess (2).

2. A method according to Claim 1, wherein the highly reflective layer (4) is sprayed on by means of an ink-jet printing method.

3. A method according to any one of Claims 1 or 2, wherein the highly reflective layer (4) is formed at least from a UV-stable and/or temperature-stable material.

4. A method according to any one of Claims 1 to 3, wherein the highly reflective layer (4) is formed at least from an ink, which is based on highly reflective particles.

5. A method according to Claim 4, wherein the highly reflective particles have a diameter, which is in a range of approximately 1 nm to 2 µm.

6. A method according to any one of Claims 1 to 5, wherein the highly reflexive layer (4) is sprayed on approximately 5 to 50 µm thick.

## Revendications

1. Procédé de revêtement d'un circuit imprimé (1) d'un module à LED (10), le circuit imprimé (1) comprend au moins un évidement (2) et une surface (3) et une couche hautement réfléchissante (4) étant pulvérisée sur la surface (3), la couche hautement réfléchissante (4) étant pulvérisée au moyen d'un jet de pulvérisation sur la surface (3),
**caractérisé en ce que**
le jet de pulvérisation peut être orienté, l'orientation du jet de pulvérisation étant choisie et/ou modifiée de façon à ce que la couche hautement réfléchissante (4) soit également pulvérisée uniformément sur les parois de limitation latérales (2a) de l'au moins un évidement (2).

2. Procédé selon la revendication 1, la couche hautement réfléchissante (4) étant pulvérisée à l'aide d'un procédé d'impression à jet d'encre.

3. Procédé selon l'une des revendications 1 ou 2, la couche hautement réfléchissante (4) étant constituée d'au moins un matériau résistant aux UV et/ou résistant à la température.

4. Procédé selon l'une des revendications 1 à 3, la couche hautement réfléchissante (4) étant constituée d'au moins une encre à base de particules hautement réfléchissantes.

5. Procédé selon la revendication 4, les particules hautement réfléchissantes présentant un diamètre qui se trouve dans un intervalle d'environ 1 nm à 2 µm.

6. Procédé selon l'une des revendications 1 à 5, la couche hautement réfléchissante (4) étant pulvérisée sur une épaisseur d'environ 5 à 50 µm.
